# EUROPÄISCHE PATENTSCHRIFT

(11) **EP 1 415 018 B1**
(45) Veröffentlichungstag und Bekanntmachung des Hinweises auf die Patenterteilung: **15.10.2008**
(21) Anmeldenummer: 02762433.7
(22) Anmeldetag: 07.08.2002
(51) Int. Cl.: C23C 16/515, C23C 16/30, C23C 16/40, B65D 65/42

(54) **VERBUNDMATERIAL AUS EINEM SUBSTRATMATERIAL UND EINEM BARRIERESCHICHTMATERIAL**
COMPOSITE MATERIAL MADE FROM A SUBSTRATE MATERIAL AND A BARRIER LAYER MATERIAL
MATERIAU COMPOSITE CONSTITUE D'UN SUBSTRAT ET D'UNE COUCHE BARRIERE

(30) Priorität: 07.08.2001 DE 10139305
(43) Veröffentlichungstag der Anmeldung: 06.05.2004
(73) Patentinhaber: Schott AG, 55122 Mainz (DE)
(72) Erfinder: BEHLE, Stephan, 55278 Hahnheim (DE); KLIPPE, Lutz, 65187 Wiesbaden (DE); BICKER, Matthias, 55126 Mainz (DE); WALTHER, Marten, 55270 Engelstadt (DE)
(74) Vertreter: Herden, Andreas F.
(86) Internationale Anmeldenummer: PCT/EP2002/008853
(87) Internationale Veröffentlichungsnummer: WO 2003/014415

(56) Entgegenhaltungen:
- EP-A- 0 709 485
- EP-A- 1 022 354
- WO-A-96/33098
- DE-A- 19 634 795
- US-A- 6 136 386

## Beschreibung

Die Erfindung betrifft ein Verbundmaterial mit einem Substratmaterial und wenigstens einer auf einer Seite des Substratmaterials aufgebrachten Barrierebeschichtung sowie ein Verfahren zum Herstellen eines Verbundmaterials, umfassend ein Substratmaterial und wenigstens eine Barrierebeschichtung.

Um im Bereich von Kunststoffverpackungen für eine Reduktion der Permeation von Gasen und Flüssigkeiten zu sorgen sowie das Kunststoffmaterial gegen chemische Angriffe oder UV-Strahlung zu schützen, ist es vorteilhaft, Substratmaterialien, insbesondere Kunststoffsubstrate, mit einer Barrierebeschichtung zu versehen. Durch Barrierebeschichtungen können mit kostengünstigen Massenkunststoffen dieselben Eigenschaft wie bei teuren Spezialkunststoffen erreichen und den Ersatz von beispielsweise Glas im Bereich der Pharmaverpackungen durch derartige Massenkunststoffe ermöglichen. Aufbringen von Barrierebeschichtungen auf ein Kunststoffsubstrat sind aus nachfolgenden Anmeldungen bekanntgeworden:
US 5,798,139
US 5,833,752
US 6,001,429

Die US 5,798,139 beschreibt die Herstellung von Plastikbehältern mit einer Kohlenstoffilmbeschichtung. Der Kohlenstoffilm soll eine Gasbarriere darstellen und das Problem der Sorption aus dem Kunststoffmaterial lösen.

Aus der US 5,833,752 ist ein System bekanntgeworden, bei dem die Barrierebeschichtung aus einem Plasma aufgebracht wird. Die Energie zur Aufrechterhaltung des Plasmas wird durch Einrichtungen aufgebracht, die sich dadurch auszeichnen, daß die Energie in das Innere der zu beschichtenden Behältern über eine Außenelektrode eingebracht wird.

Aus der US 6,001,429 ist wiederum das Aufbringen einer Sperrschicht auf die Innenfläche eines Kunststoffsubstrates bekanntgeworden, wobei HMDSO als Monomer-Gas zusammen mit einem Sauerstoffträger-Gas in das Innere des zu beschichtenden Artikels geleitet wird.

Die EP 0 709 483 A beschreibt einen Kunststoffbehälter mit einer Sperrbeschichtung, die eine Wechselschicht aus organischen und anorganischen Schichten umfasst.

Es ist nunmehr Aufgabe der Erfindung, ausgehend von dem Stand der Technik , ein Verbundmaterial anzugeben sowie ein Verfahren zur Herstellung eines derartigen Verbundmaterials, das sich durch eine verbesserte Barrierewirkung und eine verbesserte Haftung auf dem Kunststoffmaterial auszeichnet.

Erfindungsgemäß wird die Aufgabe durch ein Verbundmaterial gemäß Anspruch 1 sowie ein Verfahren gemäß Anspruch 18 gelöst. Weitere, bevorzugte Ausführungs möglichkeiten sind den Unteransprüchen zu entnehmen. Die Erfinder haben herausgefunden, daß durch den Einsatz eines Plasma-unterstützten CVD-Verfahrens, eines sogenannten PICVD-Verfahrens, die erforderliche gute Haftung erreicht wird, ebenso eine hervorragende Barrierewirkung gegen Stoffe aus der Atmosphäre, in Kunststoff enthaltenen oder hieraus abgespaltenen Substanzen sowie Stoffen, die in Kontakt mit der Oberfläche des Verbundmaterials stehen. Insbesondere ermöglicht der Einsatz eines PICVD-Verfahrens Oberflächentemperaturen von typischerweise 50 bis 150°C, d.h. ohne Schädigung der Kunststoffoberfläche können thermisch empfindliche Kunststoffe mit einer ausgezeichneten Barrierebeschichtung versehen werden. Mit Hilfe der PICVD-Verfahren können sehr dünne Schichten auf ein Substratmaterial, bis herab zu monomolekularen Schichten, aufgebracht werden, die Barriereeigenschaften aufweisen. Hierdurch ist eine erhebliche Materialersparnis möglich. Des weiteren zeichnen sich derartige Schichten durch eine hohe Flexibilität aus.

Die Verwendung eines PICVD-Verfahrens ermöglicht auch den Einsatz auf Mehrplatzanlagen, was insbesondere einen hohen Durchsatz zur Folge hat.

Besonders gute Barrierewirkungen lassen sich außerdem mit einer Barrierebeschichtung auf wenigstens einer Seite des Substratmaterials erzielen, die mittels chemischer Plasma-Impuls-Bedampfung (PICVD) aufgebracht wird und erfindungsgemäß wenigstens eines der nachfolgenden Materialien umfaßt:
SiOₓ mit x<2, insbesondere mit 1,7 ≤ x < 2;
SiOₓ mit x>2, insbesondere mit 2 < x ≤ 2,5;
TiOₓ mit x<2, insbesondere mit 1,7 ≤ x < 2;
TiOₓ mit x>2, insbesondere mit 2 < x ≤ 2,5.

Solche leicht unter- oder überstöchiometrischen Schichtzusammensetzungen ergeben sehr dichte und kompakte Schichtstrukturen mit langen Diffusionswegen.

Die Barrierebeschichtung kann auch besonders vorteilhaft eine senkrecht zur beschichteten Oberfläche des Substrats variierende Zusammensetzung oder Struktur aufweisen. Die Variation kann dabei stetig oder stufenweise sein. Eine stufenweise Variation ergibt eine mehrschichtige Barrierebeschichtung. Beispielsweise kann die unterste Schicht, die mit der Oberfläche des Substrats in Kontakt ist, als Haftvermitlerschicht für die darauffolgenden Beschichtungen dienen. Solche Schichten können zum Beispiel durch kontinuierliche oder stufenweise Änderung des Precursor-Anteils im Prozeßgas während der Beschichtung hergestellt werden.

Solche Barrierebeschichtungen umfassen erfindungsgemäß eine TiOₓ/SiOₓ-Wechselschicht . Bevorzugt ist dabei die TiOₓ-Schicht mit dem Substrat in Kontakt. Beispielsweise können die einzelnen Schichten der Wechselschicht mit einer Dicke von 5 nm bis 100nm hergestellt werden. Mit einer etwa 100 nm dicken Schicht kann eine besonders hohe Barrierewirkung erreicht werden. Um einen großen Durchsatz und damit eine bessere Wirtschaftlichkeit zu erreichen, sind aber ebenso auch Beschichtungen mit niedrigeren Schichtdicken vorteilhaft.

Besonders gute Beschichtungseigenschaften lassen sich dabei auch mit Mehrfach-Wechselschichten erreichen. Eine solche Mehrfach-Wechselschicht kann beispielsweise eine TiOₓ/SiO_{x/}TiOx/SiOₓ/-Wechselschicht umfassen. Derartige Wechselschichten können besonders vorteilhaft für die Beschichtung von Folien, auch für eine beidseitige Beschichtung verwendet werden. Folien besitzen aufgrund der im allgemeinen nur geringen Materialstärke nur eine schlechte Barrierewirkung, so daß die gute Barrierewirkung der Wechselschichten dennoch für geringe Diffusionsraten durch die Folie sorgt.

Das Kunststoffsubstrat umfaßt bevorzugt eines oder mehrere der nachfolgenden Materialien:
polycyclische Kohlenwasserstoffe, Polycarbonate, Polyethylenterphthalate,
Polystyrol, Polyethylen, insbesondere HDPE, Polypropylen, Polymethylmetacrylat, PES. Insbesondere ist es möglich, durch das Aufbringen mittels eines PICVD-Verfahrens polyzyklische Kohlenwasserstoffe, wie COC, die bereits selbst einen hochdichten Barrierekunststoff darstellen, derart zu beschichten, daß dieser hochdichte Barrierekunststoff vor einem Angriff durch organische Stoffe, insbesondere Fetten, geschützt wird.

In einer bevorzugten Ausführungsform weist die Barrierebeschichtung eine Dicke < 1000 nm, bevorzugt < 300 nm auf. Derartige Barriereschichten weisen neben guten Barriereeigenschaften auch eine hohe Flexibilität auf. Des weiteren können bei derartig dünnen Schichten insbesondere auch intrinsische Spannungen, die zu einem Abplatzen der Barriereschicht führen können, vermieden werden. In einer besonders bevorzugten Ausführungsform hat die Barriereschicht noch weitere zusätzliche Funktionen, beispielsweise optische oder elektrische Funktionen oder Antikratz- oder Antireflexfunktionen. Beispielsweise kann eine optische Interferenzbeschichtung, die gleichzeitig als Barriereschicht wirkt, in organischen LEDs, sogenannten OLEDs, zum Einsatz gelangen oder aber im Bereich von Photovoltaik-Zellen.

Es ist mit der Erfindung aber auch möglich, noch sehr viel dünnere Schichten herzustellen. Solche Barrierebeschichtungen können Dicken ab 5 nm, bevorzugt ab 15 nm, insbesondere ab 20 nm aufweisen.
Neben dem Verbundmaterial stellt die Erfindung auch ein Verfahren zum Herstellen eines derartigen Verbundmaterials zur Verfügung, das sich dadurch auszeichnet, daß in einem Beschichtungsreaktor mittels eines Pulses ein Plasma erzeugt wird, wodurch in den Reaktor eingeleitete Precursor-Gase mit der Gasatmosphäre im Beschichtungsreaktor reagieren und auf dem Substratmaterial einer Barrierebeschichtung abgeschieden werden. Transparente Barriereschichten ergeben sich bei Verwendung nachfolgender Precursor-Materialien: HMDSN, HMDSO, PMS, Silan in N2, TiCl₄ in einer Atmosphäre aus O₂, N₂, N₂+NH₃. Mit derartigen Materialien können TiO₂, SiO₂ sowie SiₓN_{y}-Barriereschichten auf verschiedenen Kunststoffmaterialien abgeschieden werden. Eine TiO₂-Barriereschicht wird beispielsweise bei Verwendung eines TiCl₄-Precursor-Gases in einer O₂-Atmosphäre abgeschieden, eine SiO₂-Barriereschicht aus einem HMDSN-Precursor-Gas in O₂-Atmosphäre, eine Si-N-Barriereschicht bei Verwendung eines SiH₄ bzw. TMS-Precursors in N₂+NH₃-Atmosphäre.

Vorteilhaft wird dabei der Beschichtungsreaktor evakuiert, nachdem das Substratmaterial in den Beschichtungsreaktor eingebracht wird und bevor Precursor-Gase eingeleitet werden. Damit kann eine Einschleusung der zu beschichtenden Substrate von Atmosphärendruck in einen evakuierten Reaktor entfallen.

Das zu beschichtende Substratmaterial kann auch insbesondere einen Hohlkörper umfassen. Mit dem erfindungsgemäßen Verfahren kann so eine Beschichtung auf der Innenseite und/oder der Außenseite des Hohlkörpers abgeschieden werden. Vorteilhaft ist bei einer Innenbeschichtung auch, vor der Beschichtung die Umgebung des Hohlkörpers auf einen Druck kleiner als 200mbar, bevorzugt zwischen 10 und 100mbar und gleichzeitig den Innenraum des Hohlkörpers auf einen Basisdruck kleiner als 1mbar, bevorzugt zwischen 0,3 und 0,05 mbar zu evakuieren, so daß auf den Wandungen des Hohlkörpers keine großen Druckunterschiede wirken, die bei dünnwandigem Material zur Verformung des Hohlkörpers führen könnten. Ferner ist für die ausschließliche Innenbeschichtung der Außendruck vorteilhaft so gewählt, dass im Außenraum kein Plasma gezündet wird. Um bereits während des Abpumpens große Druckunterschiede zu vermeiden, kann dabei vorteilhaft zunächst gleichmäßig so abgepumpt werden, daß der obengenannte Außendruck erreicht ist und dann anschließend nur innenseitig bis zu einem Basisdruck kleiner als 1mbar, bevorzugt zwischen 0,05 und 0,3 mbar abgepumpt werden.

Die O₂-Durchlässigkeit wird gemäß der DIN 53380 bestimmt, deren Offenbarungsgehalt vollumfänglich in die vorliegende Anmeldung mitaufgenommen wird. Gemäß der DIN 53380 wird bei Folien der Probekörper zwischen die beiden Teile der Permeationskammer gasdicht eingespannt. Durch den einen Kammerteil strömt langsam Stickstoff, durch den anderen Kammerteil strömt langsam Sauerstroff. Der durch die Folie in das Stickstoff-Trägergas wandernde Sauerstoff wird zu einem elektrochemischen Sensor transportiert, wo der Sauerstoff eine elektrische Stromstärke bewirkt, die proportional dem Sauerstoff-Stoffmengenstrom ist.

Werden Hohlkörper untersucht, dann wird der Stickstoff-Trägergasstrom direkt durch den Hohlkörper geleitet. Der Sauerstoff wirkt von außen auf den Hohlkörper ein.

Insbesondere die TiO₂-Barriereschich und die SiO₂-Barriereschicht, die mittels eines PICVD-Verfahrens nach der zuvor beschriebenen Art und Weise hergestellt wurden, zeichnen sich durch besonders gute Barriereeigenschaften aus. So ist die Sauerstoff-Permeation sowie die Wasserdampf-Permeation der beschichteten Materialien, wie nachfolgende Tabelle zeigt, durch die Barrierebeschichtung gegenüber den unbeschichteten Substratmaterial wesentlich erhöht. Ebenso zeigt die Beschichtung von SiO₂ auf Polycarbonat eine erhöhte Lösungsmittelbeständigkeit. Die Barrierewirkung wird in Tabelle 1 in BIF angegeben. BIF ist dabei der Quotient aus der gemessenen O₂- bzw. Wasserdampfdurchlässigkeit des unbeschichteten Körpers/O₂- bzw. Wasserdampfdurchlässigkeit des beschichteten Körpers.

Die Wasserdampfdurchlässigkeit des unbeschichteten und des beschichteten Körpers wird gemäß DIN 53122 bestimmt, deren Offenbarungsgehalt vollumfänglich in die vorliegende Anmeldung mitaufgenommen wird. Gemäß der DIN 53122 wird eine Schale mit Absorptionsmittel durch die Probe mittels Wachs verschlossen und in einem Feuchtklima gelagert.

Die Wasserdampfmenge, die durch die Probe hindurchtritt, wird aus der Gewichtszunahme der Schale errechnet, sobald diese Zunahme linear mit der Zeit verläuft.

Der für qualitativ gute Beschichtungen günstige Bereich der Mikrowellenleistung liegt dabei zwischen 300W und 12 kW, insbesondere zwischen 600W und 11 kW Pulsleistung.

Die Erfindung soll nachfolgend anhand der Ausführungsbeispiele und der Figuren näher erläutert werden.

Es zeigen:
Figur 1: einen PICVD-Beschichtungsplatz für einen Hohlkörper
Figur 2: einen PICVD-Beschichtungsplatz für eine Folie

**Tabelle 1: Wirkung der Barrierebeschichtung**

| Material | Beschichtung | Dicke [nm] | Wasserdampfbeständigkeit [BIF] | O₂-Beständigkeit [BIF] | Lösungsmittel-Beständigkeit |
|---|---|---|---|---|---|
| COC | SiO₂ | 20 - 100 | 3 | >10 | |
| PC | SiO₂ | 20 - 100 | 3 | >24 | Azeton > 10 min |
| PET | SiO₂ | 20 - 100 | 2 | >20 | |
| | SiO₂ | 20 - 100 | >50 | | |
| | 2xTiO₂ | 20 - 100 | >10² | >10² | |
| PES | 2xSiO₂ | 20 - 100 | >6 x 10² | >6 x 10² | |
| HDPE | | 20 - 100 | >10 | | |
| PP | SiO₂ | 20 - 100 | | >2 | |

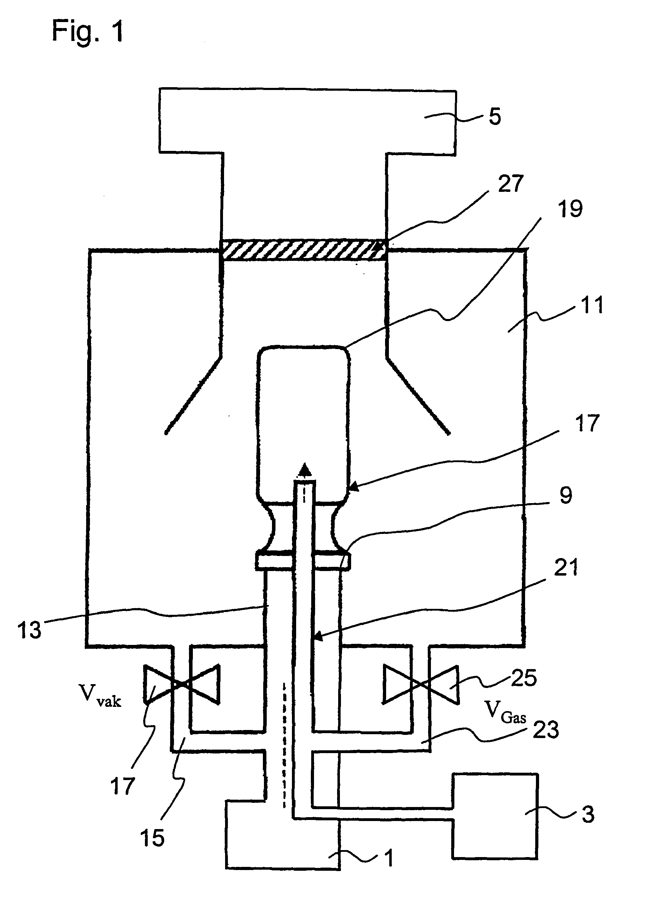

Nachfolgend soll ein Ausführungsbeispiel der Erfindung gegeben werden, wobei Polycarbonat als Substratmaterial in Form eines Hohlkörpers gewählt wurde. Der Polycarbonat-Hohlkörper wurde mit einer O₂/H₂O-Barriereschicht gemäß der Erfindung versehen. Die Flaschen wurden auf einem PICVD-Beschichtungsplatz für Glasflaschen, wie beispielsweise in ähnlicher Form in der US 5736207 beschrieben beschichtet. Die für die Beschichtungen verwendete Vorrichtung unterscheidet sich von der in der US 5736207 offenbarten Vorrichtung hinsichtlich der Größe der aufnehmbaren, zu beschichteten Substrate. In der für die erfindungsgemäße Beschichtung verwendeten Vorrichtung können Substrate mit einem Volumen von bis zu 5000 ml aufgenommen und beschichtet werden. Eine Ausführungsform eines derartigen Beschichtungsplatzes für 3D-Körper, beispielsweise Fläschchen oder Ampullen, ist in Figur 1 gezeigt. Der Beschichtungsplatz gemäß Figur 1 umfaßt eine Vakuumapparatur 1, einen Gaserzeuger 3 sowie einem Mikrowellenerzeuger 5 zur Erzeugung von Mikrowellen, die wiederum im Beschichtungsreaktor, der vorliegend von dem zu beschichtenden 3D-Hohlkörper 7 ausgebildet wird, für eine vorbestimmte Zeit ein Plasma erzeugen. Des weiteren umfaßt der Beschichtungsplatz eine Aufnahmevorrichtung 9 zur Halterung der innen zu beschichtenden 3D-Hohlkörper 7. Die 3D-Hohlkörper 7 können in einer ersten Ausführung nur innen evakuiert werden. Um mechanische Verformungen während der Beschichtung zu vermeiden, besteht auch die Möglichkeit, den Raum außerhalb des zu beschichtenden Hohlkörpers zu evakuieren. Hierfür ist um den 3D-Hohlkörper 7 ein evakuierbarer Rezipient 11 angeordnet. Ein derartiger Aufbau gibt die Möglichkeit, alternativ oder gleichzeitig zur Innenbeschichtung eine Außenbeschichtung durchzuführen.

Die Evakuierung von 3D-Hohlkörper bzw. Rezipient geschieht mit Vakuumpumpeinrichtungen gemäß dem Stand der Technik. Das vom Hohlkörper umschlossene und zu evakuierende Volumen liegt dabei vorzugsweise in einem Bereich von 10 ml bis 5000 ml, insbesondere in einem Bereich von 50 ml bis 2000 ml.

Die Evakuierung des 3D-Hohlkörpers wird über Vakuumleitung 13 vorgenommen, die des Rezipienten 11 über Vakuumleitung 15. Um den Rezipienten 11 optional zusätzlich zum Innenraum des 3D-Hohlkörpers evakuieren zu können, ist ein Ventil 17 vorgesehen. Wie zuvor erwähnt bildet in vorliegendem Ausführungsbeispiel die Innenwand 19 des 3D-Hohlkörpers 7 selbst die eigentliche Beschichtungskammer. Anschließend an die Evakuierung des Inneren des 3D-Hohlkörpers 7 wird das Innere des Hohlkörpers über Zuleitung 21 mit einem Precursor-Gas, beispielsweise mit einem Gemisch HMDSN oder HMDSO sowie Sauerstoff gefüllt, wobei die Konzentration von HMDSO/HMDSN beispielsweise im Bereich zwischen 1 bis 10 % des Sauerstofflusses liegt. Optional zur Einleitung des Precursor-Gases und Sauerstoff in das Innere des zu beschichtenden 3D-Hohlkörpers 7 kann über Zuleitung 23 Precursor-Gas und Sauerstoff zur Außenbeschichtung in den Rezipienten 11 geleitet werden. In der Zuleitung 23 ist wiederum ein Ventil 25 angeordnet. Der Druck im Beschichtungsreaktor liegt nach Befüllung zwischen 1,2 und 0,2 mbar. Nach der Evakuierung wird Mikrowellenleistung in den zu beschichtenden 3D-Hohlkörper 7 bzw. den Rezipienten 11 eingekoppelt. Das Einkoppeln der Mikrowellenleistung vom Mikrowellenerzeuger 5, der beispielsweise ein Magentron sein kann, in den Rezipienten bzw. 3D-Hohlkörper wird über ein oberhalb des 3D-Hohlkörpers 7 angeordnetes dielektrisches Fenster 27 vorgenommen. Andere Arten der Einkopplung, beispielsweise über Antennen, wären möglich. Mit Hilfe der zugeführten Mikrowellenleistung, die bevorzugt zeitmoduliert ist, wird ein gepulstes Plasma innerhalb des Hohlkörpers erzeugt. Typische Pulsdauern liegen zwischen 0,1 und 20ms, die Pulspause im Bereich von 5 bis 400ms. Die Vorteile der erfindungsgemäßen Beschichtung mit Hilfe von Pulsen liegt in der geringen Wärmebelastung des Kunststoffsubstrats. Des weiteren kann innerhalb der Pulspausen ein vollständiger Gasaustausch durchgeführt werden, so daß zu Beginn des nächsten Mikrowellenpulses stets eine ideale Gaszusammensetzung vorliegt. Die oben genannten Parameterbereiche für Pulspause und Pulsdauer erweisen sich dabei als besonders günstig, um einen guten Gasaustausch bei gleichzeitig niedriger Wärmebelastung und schnellem Schichtwachstum zu gewährleisten. Die Ergebnisse der nach zuvor beschriebenem Verfahren beschichteten Hohlkörper sind in nachfolgender Tabelle zusammengefaßt:

**Tabelle 2:Innenbeschichtete Polycarbonat-Flaschen mit O₂/H₂O-Barriere, Schichtdicke: 100 nm**

| Druck [mBar] | O₂-Fluß | HMDSN [sccm] | Pulsdauer [ms] | Pulspause [ms] | Mittlere MW-Leistung (Pulsleistung) | Barriereverbesser ungsfaktor H₂O | Barriereverbesser ungsfaktor O₂ |
|---|---|---|---|---|---|---|---|
| 1 - 0,3 | 200 - 50 | 5 - 0,1 | 2,0 - 0,5 | 50 - 10 | 100W - 200W (2,0 kW-4,0 kW) | 3 | 2 - 20 |

Alternativ zur Beschichtung von 3D-Hohlkörpern ist gemäß der Erfindung auch die Beschichtung von flächenförmigen Substraten, beispielsweise von Folien, oder von Platten möglich. Plattenförmige Substrate können beispielsweise Displayabdeckungen für LCD-Displays sein. In diesem Zusammenhang können die Barrierebeschichtungen auch andere funktionelle Eigenschaften, wie beispielsweise eine Entspiegelung oder eine Antikratzbeschichtung bereitstellen.

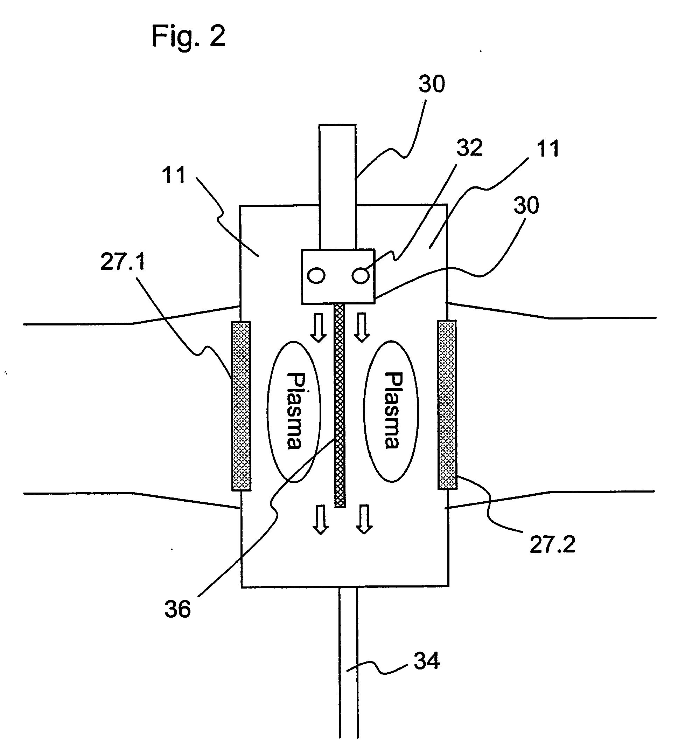

Eine Beschichtungsvorrichtung für derartige Körper zeigt Figur 2. Gleiche Bauteile wie in Figur 1 sind mit denselben Bezugsziffern belegt. Im Gegensatz zu Figur 1 bildet der zu beschichtende Gegenstand nicht selbst die Beschichtungskammer, sondern wird in einem Rezipienten 11 mittels einer Halterung 30 gehalten. Die Halterung 30 umfaßt Gasauslässe 32, aus denen Precursor-Gas und Sauerstoff in den Rezipienten 11 geleitet wird, nachdem der Rezipient über Leitung 34 evakuiert wurde. Mittels der beidseits des Rezipienten über dielektrische Fenster 27.1, 27.2 eingekoppelten Mikrowellenleistung wird innerhalb des Rezipienten 11 ein Plasma gezündet und das Substrat 36 beschichtet. Vorzugsweise wird die Mikrowellenleistung gepulst.

Der Vorteil der Plasmaanregung mit Hilfe von Mikrowellen, d.h. einer Frequenz von 90 - 3000 MHz, insbesondere 300 - 2500MHz, gegenüber einer Anregung mit Hochfrequenz (HF) wie im Stand der Technik, ist insbesondere, die bei Anregung mit Mikrowellen dünnere Randschicht. In einer dünnen Randschicht können die Ionen des Plasmas nur wenig Energie aufnehmen, so daß sie nur mit geringer kinetischer Energie auf das zu beschichtende Substrat treffen und dort nur geringe Zerstörungen, beispielsweise aufgrund von Hitzeeintrag oder Aufladung, auslösen können. Aufgrund dieser Vorteile kann das Plasma bei Mikrowellen mit wensentlich höheren Leistungen und höheren Drücken als im Stand der Technik betrieben werden, wodurch sich beispielsweise Vorteile in der Abscheiderate ergeben.

Auch eine Anregung mit gepulster Hochfrequenz kann jedoch von Vorteil für verschiedene Anwendungen sein, um beispielsweise bei langer Wellenlänge homogenere Feldverteilungen im Plasma und damit besonders gleichmäßige Beschichtungen zu erzeugen. Geeignet ist dabei der Frequenzbereich unterhalb von 90 MHz, insbesondere im Bereich von 10 MHz bis 90 MHz.

Durch die Erfindung wird erstmals ein Verbundmaterial mit verbesserten Barriereeigenschaften sowie ein Herstellverfahren für ein derartiges Material zur Verfügung gestellt.

Nachfolgend soll die Erfindung anhand der Ausführungsbeispiele näher erläutert werden:
Ausführungsbeispiele 1-5,10,11 beschreiben die Herstellung von Einzelschichen, die im Verbundmaterial gemäß Anspruch 1 verwendet werden.

### Ausführungsbeispiel 1:

Eine Flasche aus Polyethylenterephtalat (PET) mit einem Füllvolumen von 0,5 1 wird gleichzeitig außenseitig auf einen Druck von 85 mbar evakuiert und innenseitig zunächst auf einen Basisdruck niedriger als 0,09 mbar abgepumpt. Anschließend wird in den Innenraum der Flasche bei einem Druck von 0,3 mbar ein Gemisch aus Sauerstoff und Hexamethyldisilazan (HMDSN) geleitet. Dann wird gepulste Mikrowellenenergie mit einer Pulsleistung von 5 kW und einer Frequenz von 2,45GHz eingekoppelt und ein Plasma im Behälter gezündet. Die Beschichtung wird mit einer Wachstumsrate von etwa 0,89 nm Schichtdickenzuwachs pro Sekunde vorgenommen.

### a) Sauerstoff- und Wasserdampfbarriere:

Während einer Zeit von 90 Sekunden wird der Behälter innenseitig mit 80 nm SiOₓ beschichtet Dies entspricht einer Wachstumsrate von 0,89 nm/s. Unmittelbar darauf wird die Flasche begast und ausgebaut. Messungen der Wasserdampf-Permeation nach DIN 53122, Blatt 1 mit einem gravimetrischen Meßverfahren ergeben für die beschichtete Flasche einen Wert von 14,3 mg/(Probe x Tag), während für die unbeschichtete Flasche eine Wasserdampf-Permeation von 28,0 gm/(Probe x Tag) gemessen wird. Daraus berechnet sich ein Barriereverbesserungsfaktor (BIF = Barrier Improvement Factor) von 2,0. Messungen der Sauerstoffdurchlässigkeit nach DIN 53380-3 mit einem elektrochemischen Sensor ergeben für die beschichtete Flasche einen Wert von 0,018 cm³/(Probe x Tag x bar) und für die unbeschichtete Flasche einen Wert von 0,15 cm³/(Probe x Tag x bar), so daß der O₂-BIF 8,3 beträgt.

### b) Sauerstoff- und Wasserdampfbarriere in kurzer Beschichtungszeit:

Eine Innenbeschichtung von SiOₓ mit einer Schichtdicke von 20 nm erfolgt in 18 Sekunden, was einer Abscheiderate von etwa 1,1 nm/s entspricht. Der Behälter wird anschließend mit Gas geflutet und aus der Apparatur entnommen. Messungen der Wasserdampf-Permeation ergeben für die beschichtete Flasche einen Wert von 25,3 mg/(Probe x Tag). Daraus berechnet sich ein H₂O-BIF von 1,1. Messungen der Sauerstoffdurchlässigkeit ergeben einen Wert von 0,036 cm³/(Probe x Tag x bar), so daß der O₂-BIF 4 beträgt.

### c) Sauerstoffbarriere in sehr kurzer Beschichtungszeit, geringe Erwärmung:

In 9 Sekunden wird die Flasche innenseitig mit SiOₓ mit einer Schichtdicke von 10 nm beschichtet. Der Behälter wird anschließend mit Gas geflutet und aus der Aparatur entnommen. Messungen der Sauerstoffdurchlässigkeit ergeben einen Wert von 0,062 cm³/(Probe x Tag x bar) und damit einen O₂-BIF von 2. Durch die kurze Beschichtungszeit wird die Probe nur geringfügig erwärmt.

### d) Kontrolle der Heizrate durch Pulsdauer und Pulspause:

Durch geeignete Wahl von Pulsdauer und Pulspause kann die Erwärmung der Proben während der Beschichtung gezielt beeinflußt werden. Es können bei 1000 W Mikrowellenleistung, bei Pulsdauern von 0,5 ms und Pulspausen von 200 ms Heizraten von kleiner als 0,3° C/s erzielt werden. Gerade für die Beschichtung von Kunststoffen ist dieses von Vorteil, weil viele Kunststoffe, wie zum Beispiel PET, schon bei Temperaturen oberhalb von 80° C sich verformen und kristallisieren, wodurch Rißbildung in der Schicht entstehen kann oder die Schicht vom Kunststoffsubstrat abplatzen kann.

### Ausführungsbeispiel 2 :

### Hohe Sauerstoffbarriere bei niedriger Mikrowellenleistung:

Eine 0,5 1-Flasche aus Polyethylenterephtalat (PET) wird gleichzeitig außenseitig auf einen Druck von 85 mbar evakuiert und innenseitig zunächst auf einen Basisdruck niedriger als 0,09 mbar abgepumpt. Anschließend wird in den Innenraum der Flasche bei einem Druck von 0,4 mbar ein Gemisch aus Sauerstoff und Hexamethyldisilazan (HMDSN) geleitet. Dann wird gepulste Mikrowellenenergie mit einer Pulsleistung von 1000 W und einer Frequenz von 2,45 GHz eingekoppelt und damit ein Plasma im Behälter gezündet.

Es wird eine 100 nm dicke SiOₓ-Einzelschicht in 98,4 Sekunden aufgebracht, was einer Abscheiderate von etwa 1 nm/s entspricht. Anschließend wird die Probe mit Stickstoff geflutet und ausgebaut. Messungen der Wasserdampf-Permeation ergeben einen Wert von 18,7 mg/(Probe x Tag) für eine beschichtete und 22,5 mg/(Probe x Tag) für eine unbeschichtete Flasche. Daher beträgt der H₂O-BIF 1,2. Die Sauerstoff-Permeation beträgt 0,0015 cm³/(Probe x Tag x bar) für eine beschichtete und 0,18 cm³/(Probe x Tag x bar) für eine unbeschichtete Flasche. Daraus ergibt sich ein O₂-BIF von 82.

### Ausführungsbeispiel 3: Doppelschicht mit verbesserter Haftung:

### 1. Variante:

Ein Substrat, beispielsweise eine 0,5 1-Flasche aus Polyethylenterephtalat (PET) wird gleichzeitig außenseitig auf einen Druck von 85 mbar evakuiert und innenseitig zunächst auf einen Basisdruck niedriger als 0,09 mbar abgepumpt. Anschließend wird in den Innenraum der Flasche bei einem Druck von 0,4 mbar zunächt ein Gemisch aus Sauerstoff und Hexamethyldisilazan (HMDSN) mit einem hohen Precursor-Anteil, der 10 % des O₂-Flusses beträgt, eingeleitet. Dann wird gepulste Mikrowellenenergie mit einer Pulsleistung von 1000 W und einer Frequenz von 2,45 GHz eingekoppelt und damit ein Plasma im Behälter gezündet. Es wird eine Schicht mit einer Dicke von 5 - 25 nm aufgebracht, die als Haftvermittler zwischen Kunststoff und Barriereschicht wirkt, welche aber auch eine geringe Sperrwirkung gegen Gase aufweisen kann. Unmittelbar darauf strömt in den Behälter ein Gemisch aus Sauerstoff und Hexamethyldisilazan (HMDSN) mit einem niedrigen Precursor-Anteil ein, der ≤ 2 % des Sauerstoff-Durchflusses beträgt. Es wird wiederum ein gepulstes Mikrowellenplasma gezündet und eine zweite Schicht mit einer Dicke zwischen 25 und 45 nm aufgebracht. Diese Schicht besitzt eine hohe Barrierewirkung gegen Gase.

### 2. Variante, Innenbeschichtung einer 0,51 PET-Flasche (Wandstärke 0.5 mm) mit einem Haftvermittler-Barriereverbund mit verbesserter Haftung:

Eine Flasche aus Polyethylenterephtalat (PET) mit einem Füllvolumen von 0,51 wird gleichzeitig außenseitig auf einen Druck von 85 mbar evakuiert und innenseitig zunächst auf einen Basisdruck niedriger als 0,1 mbar abgepumpt. Anschließend wird in den Innenraum der Flasche bei einem Druck von 0,3 mbar ein Gemisch aus Sauerstoff und Hexamethyldisilazan (HMDSN) geleitet. Dann wird gepulste Mikrowellenenergie mit einer Puls-Leistung von 1000 Watt und einer Frequenz von 2,45 GHz eingekoppelt und ein Plasma im Behälter gezündet.
i) Zunächst wird analog zur 1. Variante eine organische Haftvermittler-Schicht, aber mit einer Dicke von 100nm bei einer hohen HMDSN-Konzentration aufgebracht.
ii) Anschließend erfolgt ein schneller Gaswechsel auf eine niedrigere HMDSN-Konzentration von 2% und es wird innerhalb von 26 Sekunden eine anorganische Barriereschicht mit einer Schichtdicke von 50nm aufgebracht, was einer Rate von 1,9nm/s entspricht.

Durch die Beschichtung kann ein Haftvermittler-Barriereverbund mit einem hohen O₂-BarriereVerbesserungsfaktor (O₂-BIF) von deutlich größer 40 hergestellt werden.

Die Permeation der unbeschichteten Flasche beträgt 0,125 cm³/(ProbexTagxbar) und die der beschichteten Flasche liegt deutlich unterhalb von 0,003 cm³/(Probe× Tag×bar).

Die Auflösungsgrenze des verwendeten Mocon-Oxtran Messgerätes ist dabei erreicht worden.

### 3. Variante, Innenbeschichtung einer 0,41 PET-Flasche (Wandstärke: 0,4mm) mit einem Haftvermittler-Barriereverbund, Vergleich zwischen Barriere-Haftvermittler-Verbund und reiner Barriereschicht:

Eine Flasche aus Polyethylenterephtalat (PET) mit einem Füllvolumen von 0,41 wird gleichzeitig außenseitig auf einen Druck von 85 mbar evakuiert und innenseitig zunächst auf einen Basisdruck niedriger als 0,1 mbar abgepumpt. Anschließend wird in den Innenraum der Flasche bei einem Druck von 0,3 mbar ein Gemisch aus Sauerstoff und Hexamethyldisilazan (HMDSN) geleitet. Dann wird gepulste Mikrowellenenergie mit einer Pulsleistung von 1000 Watt und einer Frequenz von 2,45 GHz eingekoppelt und ein Plasma im Behälter gezündet.
i) Haftvermittler-Barriereverbund:
   Zunächst wird analog zur 2. Variante eine organische Haftvermittler-Schicht, aber mit einer Dicke von 10nm bei einer hohen HMDSN-Konzentration aufgebracht.

Anschließend erfolgt ein schneller Gaswechsel auf eine niedrigere HMDSN-Konzentration von 1,5% und es wird innerhalb von 11,4 Sekunden eine anorganische Barriereschicht mit einer Schichtdicke von 15nm aufgebracht.

Durch die Beschichtung kann ein Haftvermittler-Barriereverbund mit einem hohen O₂-BarriereVerbesserungsfaktor (O₂-BIF) von 18,7 hergestellt werden, wie sich aus folgenden Daten ergibt:
Die Permeation der unbeschichteten Flasche beträgt 0,196 cm³/(Probe×Tag×bar) und die der beschichteten Flasche liegt unterhalb von 0,0104 cm³/(Probe×Tag×bar).

### Ausführungsbeispiel 4:

### Gradientenschicht mit verbesserter Haftung

Eine 0,5 1-Flasche aus Polyethylenterephtalat (PET) wird gleichzeitig außenseitig auf einen Druck von 85 mbar evakuiert und innenseitig zunächst auf einen Basisdruck niedriger als 0,09 mbar abgepumpt. Anschließend wird in den Innenraum der Flasche bei einem festen Druck von zum Beispiel 0,4 mbar ein Gemisch aus Sauerstoff und Hexamethyldisilazan (HMDSN) oder Hexamethyldisiloxan (HMDSO) eingeleitet und ein gepulstes Mikrowellenplasma gezündet. Es wird auf dem Substrat eine Gradientenschicht aufgebracht, die entweder, wie in EP 0718418A1 durch kontinuierliche Änderung von mindestens einem der Parameter Pulsdauer und/oder Pulspause und während des Schichtwachstums hergestellt werden können. Alternativ kann die Gradientenschicht durch kontinuierliche oder schrittweise Veränderung von mindestens einem der Beschichtungsparameter Mikrowellenleistung, Pulsdauer, Pulspause, Sauerstoff- oder Precursor-Durchfluß hergestellt werden. Durch die Gradientenschicht wird eine verbesserte Haftung bei gleichzeitig hoher Barrierewirkung erreicht. Das Aufbringen solcher Gradientenschichten kann ebenso auch auf einem beliebiges anderes Substrat erfolgen. Diese so hergestellten Gradientenschichten weisen eine stöchiometrische oder strukturelle Variation in Richtung senkrecht zu Oberfläche auf.

### Ausführungsbeispiel 5:

### HDPE

### Variante 1

Ein Hohlkörper aus hochdichtem Polyethylen (HDPE), Volumen 70 ml, wird auf einen Druck unterhalb 0,1 mbar evakuiert. Anschließend wird bei einem Druck von 0,6 mbar ein Gemisch aus Sauerstoff und Hexamethyldisilazan (HMDSN) in den Behälter geleitet und gepulste Mikrowellenenergie mit einer Pulsleistung von 2,7 kW eingekoppelt. Es wird ein Plasma gezündet und eine SiOx-Schicht mit einer Dicke von a) 80 nm in 70 Sekunden, entsprechend einer Abscheiderate von 1,14 nm/s und b) 300 nm in 270 Sekunden, entsprechend einer Abscheiderate von 1,11 nm/s abgeschieden.

Eine unbeschichtete Probe hat eine O2-Permeation von 0,86 cm³/(Probe x Tag x bar), die 80 nm dicke Probe von 0,62 cm³/(Probe x Tag x bar) und die 300 nm dicke Probe von 0,33 cm³/(Probe x Tag x bar).

### Variante 2

Ein Hohlkörpers aus hoch dichtem Polyethylen (HDPE), Volumen 500ml, wird auf einen Druck unterhalb 0,1mbar evakuiert. Anschließend wird bei einem Druck von 0,3 mbar ein Gemisch aus Sauerstoff und Hexamethyldisilazan (HMDSN) in den Behälter geleitet und gepulste Mikrowellenenergie mit einer Pulsleistung von 1000 W eingekoppelt. Es wird ein Plasma gezündet und bei hoher HMDSN-Konzentration a) eine Haftvermittler-Schicht mit einer Dicke von 20nm abgeschieden. Auf dieser Haftvermittler-Schicht wird eine Barriere-Schicht bei mit einer Dicke von 10nm in 12 Sekunden aufgebracht, b) eine Haftvermittler-Schicht mit einer Dicke von 20nm abgeschieden. Auf dieser Haftvermittler-Schicht wird eine Barriere-Schicht mit einer Dicke von 80nm in 71,2 Sekunden aufgebracht.

Eine unbeschichtete Probe hat eine O₂-Permeation von 3,04 cm³/(Probe×Tag×bar), die entsprechend Verfahren a) hergestellte Probe 0,80 cm³/(ProbexTagxbar) und die entsprechend Verfahren b) hergestellte Probe von 0,55 cm³/ (Probe×Tag×bar). Daraus ergibt sich ein O₂-BIF von a) 3,8 und b) 5,5.

### Ausführungsbeispiel 6:

### PET-Folie

Eine 100 µm dicke PET-Folie wird in einen Rezipienten eingebaut und evakuiert. Anschließend wird ein Gemisch aus Sauerstoff und a) Titanchlorid, b) Hexamethyldisilazan in den Reaktor geleitet und ein Druck von 0,2 mbar eingestellt. Darauf wird von einer Seite Mikrowellenenergie mit einer Pulsleistung von 11 kW in den Reaktor eingekoppelt und ein Plasma gezündet.
a) Eine 100 nm dicke TiOₓ-Schicht wird auf einer Folienseite abgeschieden. Anschließend wird der Reaktor begast und die Folie entnommen. Eine Messung der Wasserdampf-Permeation nach DIN 53122, Blatt 1 ergibt für die beschichtete Folie einen Wert von 0,020 g/(m²/Tag), während für eine unbeschichtete Folie eine H₂O-Permeation von 1,96 g/(m²/Tag) bestimmt wird. Der H₂O-BIF liegt damit bei 98.
b) Eine 100 nm dicke SiOₓ-Schicht wird abgeschieden. Eine Messung der Wasserdampf-Permeation ergibt einen Wert von 0,4 g/(m²/tag) und somit einen H₂O-BIF von 4,9.

### Ausführungsbeispiel 7:

### PES-Folie, beidseitig beschichtet

Eine 25 µm dicke Folie aus Polyethersulfon (PES) wird in einen Rezipienten eingebaut und evakuiert. Anschließend wird ein Gemisch aus Sauerstoff und a) Titanchlorid, b) Hexamethyldisilazan in den Reaktor geleitet und ein Druck von 0,2 mbar eingestellt. Darauf wird jeweils von einer Seite in den Reaktor Mikrowellenenergie eingekoppelt und ein Plasma gezündet.
a) Bei einer Pulsleistung von jeweils 11 kW wird beidseitig eine 20 nm dicke TiOₓ-Schicht abgeschieden. Eine Messung der Sauerstoff-Permeation nach DIN 53380-3 ergibt für die beschichtete Folie einen Wert von 15,7 cm³/(m² x Tag x bar), während für eine unbeschichtete Folie eine O₂-Permeation von 940 m³ (m² x Tag x bar) bestimmt wird. Der O₂-BIF liegt damit bei 60.
b) Bei einer Pulsleistung von jeweils 4 KW wird beidseitig eine 100 nm dicke SiOₓ-Schicht abgeschieden. Eine Messung der Sauerstoff-Permeation ergibt einen Wert von 1,51 cm³/(m² x Tag x bar) und somit einen O₂-BIF von 620.

### Ausführungsbeispiel 8:

Eine Folie aus 1) Polystyrol (PS), 25µm dick, 2) Polycarbonat (PC), 20 µm dick, 3) Polyethersulfon (PES), 25 µm dick, 4) Hartpolyethylen (HDPE), 10 µm dick, 5) Polypropylen (PP), 30 µm dick und 6) fluoriertes Ethylen-Propylen-Copolymer (FEP) , 25 µm dick, wird in einen Rezipienten eingebaut und evakuiert. Anschließend wird ein Gemisch aus Sauerstoff und
a) Titanchlorid, b) Hexamethyldisilazan in den Reaktor geleitet und ein Druck von 0,2 mbar eingestellt. Darauf wird von einer Seite in den Reaktor Mikrowellenenergie mit einer Pulsleistung von a) 11 kW für die Herstellung von TiOₓ und b) 4 kW zur Herstellung von SiOₓ eingekoppelt und ein Plasma gezündet.
1a) Es wird eine 50 nm dicke TiOₓ-Schicht abgeschieden. Eine Messung der Wasserdampf-Permeation ergibt für die beschichtete PS-Folie einen Wert von 0,76 g/(m² x Tag), während für eine unbeschichtete PS-Folie eine H₂O-Permeation von 91 g/(m² x Tag) bestimmt wird. Der H₂O-BIF liegt damit bei 120.
1b) Es wird einseitig eine 200 nm dicke SiOₓ-Schicht abgeschieden. Eine Messung der Wasserdampf-Permeation ergibt einen Wert von 0,2 g/(m² x Tag) und somit einen H₂O-BIF von 455.
2a) Es wird einseitig eine 50 nm dicke TiOₓ-Schicht abgeschieden. Eine Messung der Wasserdampf-Permeation ergibt für die beschichtete PC-Folie einen Wert von 0,5 g/(m² x Tag), während für eine unbeschichtete PC-Folie eine H₂O Permeation von 11,5 g/(m² x Tag) bestimmt wird. Der H₂O-BIF liegt damit bei 22.
2b) Es wird einseitig eine 50 nm dicke SiOₓ-Schicht abgeschieden. Eine Messung der Wasserdampf-Permeation-ergibt einen Wert von 0,62 g/ (m² x Tag) und somit einen H₂O-BIF von 18.
3a) Es wird einseitig eine 100 nm dicke TiOₓ-Schicht abgeschieden. Eine Messung der Wasserdampf-Permeation ergibt für die beschichtete PES-Folie einen Wert von 3,69 g/(m² x Tag), während für eine unbeschichtete PES-Folie eine H₂O-Permeation von 234,35 g/(m² x Tag) bestimmt wird. Der H₂O-BIF liegt damit bei 63.
3b) Es wird einseitig eine 50 nm dicke SiOₓ-Schicht abgeschieden. Eine Messung der Wasserdampf-Permeation ergibt einen Wert von 4,13 g/(m² x Tag) und somit einen H₂O-BIF von 56.
4a) Es wird einseitig eine 50 nm dicke TiOₓ-Schicht abgeschieden. Eine Messung der Wasserdampf-Permeation ergibt für die beschichtete HDPE-Folie einen Wert von 1,11 g/(m² x Tag), während für eine unbeschichtete HDPE-Folie eine H₂O-Permeation von 6,63 g/(m² x Tag) bestimmt wird. Der H₂O-BIF liegt damit bei 6.
4b) Es wird einseitig eine 200 nm dicke SiOₓ-Schicht abgeschieden. Eine Messung der Wasserdampf-Permeation ergibt einen Wert von 1,04 g/(m² x Tag) und somit einen H₂O-BIF von 6,3.
5a) Es wird einseitig eine 50 nm dicke TiOₓ-Schicht abgeschieden. Eine Messung der Wasserdampf-Permeation ergibt für die beschichtete PP-Folie einen Wert von 0,32 g/(m² x Tag), während für eine unbeschichtete PP-Folie eine H₂O-Permeation von 0,42 g/(m² x Tag) bestimmt wird. Der H₂O-BIF liegt damit bei 1,3.
5b) Es wird einseitig eine 50 nm dicke SiOₓ-Schicht abgeschieden. Eine Messung der Wasserdampf-Permeation ergibt einen Wert von 0,33 g/ (m² x Tag) und somit einen H₂O-BIF von 1,3.
6a) Bei einer Pulsleistung von jeweils 11 kW wird einseitig eine 50 nm dicke TiOₓ-Schicht abgeschieden. Eine Messung der Wasserdampf-Permeation ergibt für die beschichtete FEP-Folie einen Wert von 0,55 g/(m² x Tag), während für eine unbeschichtete FEP-Folie eine H₂O-Permeation von 3,64 g/(m² x Tag) bestimmt wird. Der H₂O-BIF liegt damit bei 6,5.
6b) Bei einer Pulsleistung von jeweils 4 kW wird einseitig eine 50 nm dicke SiOₓ-Schicht abgeschieden. Eine Messung der Wasserdampf-Permeation ergibt einen Wert von 1,18 g/(m² x Tag) und somit einen H₂O-BIF von 3.

### Ausführungsbeispiel 9:

### PET-Folie mit SiOₓ/TiOₓ-Wechselschichten:

Eine 23 µm dicke PET-Folie wird in einen Rezipienten eingebaut und evakuiert. Anschließend werden im mehrfachen Wechsel die folgenden Prozesse 1) und 2) durchlaufen:
1) Ein Gemisch aus Sauerstoff und Titanchlorid wird in den Reaktor geleitet und ein Druck von 0,2 mbar eingestellt. Darauf wird von einer Seite Mikrowellenenergie mit einer Pulsleistung von 11 kW in den Reaktor eingekoppelt und ein Plasma gezündet.
2) Nach Abscheidung der TiOₓ-Schicht wird unmittelbar darauf der Reaktor mit einem Gasgemisch aus Sauerstoff und Hexamethyldisilazan (HMDSN) gespült und im Anschluß daran bei gleichen Druck, aber einer Pulsleistung von 4 kW, ein Plasma gezündet und eine SiOₓ-Schicht abgeschieden.
   a) Die Prozesse 1) und 2) werden einmal durchlaufen und eine Wechselschicht aus 100 nm TiOₓ und 100 nm SiOₓ wird abgeschieden. Anschließend wird der Rezipient begast und die Probe ausgebaut. Messungen der Wasserdampf-Permeation der beschichteten Folie ergeben einen Wert von 0,055 g/(m² x Tag) und für eine unbeschichtete Folie einen Wert von 10,87 g/(m² x Tag). Der H₂O-BIF liegt somit beim Faktor 199.
   b) Die Prozesse 1) und 2) werden zweifach durchlaufen und eine 4-fach-Wechselschicht mit Rezipient begast und die Probe ausgebaut. Messungen der Wasserdampf-Permeation der beschichteten Folie ergeben einen Wert von 0,04 g/(m² x Tag) und für eine unbeschichtete Folie einen Wert von 10,87 g/(m² x Tag). Der H₂O-BIF liegt somit beim Faktor 270.

### Ausführungsbeispiel 10:

Eine 10 ml Flasche aus Topas (COC: Cycloolefincopolymer) wird innenseitig zunächst auf einen Basisdruck niedriger als 0,09 mbar abgepumpt. Anschließend wird in den Innenraum der Flasche bei einem Druck von 0,5 mbar ein Gemisch aus Sauerstoff und Hexamethyldisilazan (HMDSN) geleitet. Dann wird gepulste Mikrowellenenergie mit einer Pulsleistung von 3,5 kW und einer Frequenz von 2,45 GHz eingekoppelt, ein Plasma im Behälter gezündet und der Behälter wird innenseitig mit 125 nm SiOₓ beschichtet. Unmittelbar darauf wird die Flasche begast und ausgebaut. Messungen der Wasserdampf-Permeation ergeben für die beschichtete Flasche einen Wert von 0,14 mg/(Probe x Tag), während für die unbeschichtete Flasche eine Wasserdampf-Permeation von 0,29 mg/(Probe x Tag) gemessen wird. Daraus berechnet sich ein Barriereverbesserungsfaktor (BIF = Barrier Improvement Factor) von 2. Messungen der Sauerstoffdurchlässigkeit ergeben für die beschichtete Flasche einen Wert von 0,047 cm³/(Probe x Tag x bar) und für die unbeschichtete Flasche einen Wert von 0,15 cm³/(Probe x Tag x bar), so daß der O₂-BIF 3,1 beträgt.

### Ausführungsbeispiel 11:

Eine 10 ml Flasche aus Polycarbonat (PC) wird innenseitig zunächst auf einen Basisdruck niedriger als 0,09 mbar abgepumpt. Anschließend wird in den Innenraum der Flasche bei einem Druck von 1,0 mbar ein Gemisch aus Sauerstoff und Hexamethyldisilazan (HMDSN) geleitet. Dann wird gepulste Mikrowellenenergie mit einer Pulsleistung von 2,8 kW und einer Frequenz von 2,45 GHz eingekoppelt und ein Plasma im Behälter gezündet. Innerhalb einer Zeit von 40,3 Sekunden wird der Behälter innenseitig mit 100 nm SiOₓ beschichtet, was einer Abscheiderate von 2,48 nm/s entspricht. Unmittelbar darauf wird die Flasche begast und ausgebaut. Messungen der Wasserdampf-Permeation ergeben für die beschichtete Flasche einen Wert von 2,3 mg/(Probe x Tag), während für die unbeschichtete Flasche eine Wasserdampf-Permeation von 6,6 mg/(Probe x Tag) gemessen wird. Daraus berechnet sich ein Barriereverbesserungsfaktor (BIF = Barrier Improvement Factor) von 2,8. Messungen der Sauerstoffdurchlässigkeit ergeben für die beschichtete Flasche einen Wert von 0,008 cm³/(Probe x Tag x bar) und für die unbeschichtete Flasche einen Wert von 0,158 cm³/(Probe x Tag x bar), so daß der O₂-BIF 19 beträgt.

## Patentansprüche

1. Verbundmaterial mit einem Substratmaterial und wenigstens einer Barrierebeschichtung auf einer Seite des Substratmaterials, wobei
- die Barrierebeschichtung wenigstens eines der nachfolgenden Materialien umfaßt:
SiOₓ mit x<2, insbesondere mit 1,7 ≤ x < 2;
SiOₓ mit x>2, insbesondere mit 2 < x ≤ 2,5;
TiOₓ mit x<2, insbesondere mit 1,7 ≤ x < 2;
TiOₓ mit x>2, insbesondere mit 2 < x ≤ 2,5,
, und die Barrierebeschichtung eine TiOₓ/SiOₓ-Wechselschicht umfaßt.

2. Verbundmaterial nach Anspruch 1, mit einem Substratmaterial und wenigstens
einer Barrierebeschichtung auf einer Seite des Substratmaterials, **dadurch gekennzeichnet, daß**
die Barrierebeschichtung auf das Substratmaterial mittels chemischer Plasma-Impuls-Bedampfung (PICVD) aufgebracht wird und
die Barrierebeschichtung wenigstens eines der nachfolgenden Materialien umfaßt:
amorphe Kohlenwasserstoffe
NbₓO_{y} mit x ∈ [0,2], y ∈ [0,5].

3. Verbundmaterial nach Anspruch 1 oder 2, **dadurch**
**gekennzeichnet, daß**
das Substrat ein Kunststoffsubstrat ist.

4. Verbundmaterial nach Anspruch 3, **dadurch**
**gekennzeichnet, daß**
das Kunststoffsubstrat eines oder mehrere der nachfolgenden Materialien
polycyclische Kohlenwasserstoffe
Polycarbonate
Polyethylenterphthalate
Polystyrol
Polyethylen, insbesondere HDPE
Polypropylen
Polymethylmetacrylat
PES
umfaßt.

5. Verbundmaterial gemäß Anspruch 4,
**dadurch gekennzeichnet, daß**
der polyzyklische Kohlenstoff COC ist.

6. Verbundmaterial nach einem der Ansprüche 1 bis 5,
**dadurch gekennzeichnet, daß**
das Substratmaterial beidseitig beschichtet ist.

7. Verbundmaterial nach einem der Ansprüche 1 bis 6,
**dadurch gekennzeichnet, daß**
die Barrierebeschichtung eine Dicke < 1000 nm.

8. Verbundmaterial nach Anspruch 7, **dadurch**
**gekennzeichnet, daß**
die Barrierebeschichtung wenigstens eine geschlossene monomolekulare Schicht umfaßt.

9. Verbundmaterial nach Anspruch 8, **dadurch**
**gekennzeichnet, daß**
die Dicke der Barrierebeschichtung >5 nm ist.

10. Verbundmaterial nach einem der Ansprüche 1 bis 9,
**dadurch gekennzeichnet, daß**
die Barrierebeschichtung eine Barriere gegen Stoffe aus der Atmosphäre und/oder Stoffe, die in direktem Kontakt mit dem Verbundmaterial stehen und/oder im Substratmaterial enthalten oder aus diesem abgespalten werden, bildet.

11. Verbundmaterial nach einem der Ansprüche 1 bis 10,
**dadurch gekennzeichnet, daß**
das Verbundmaterial eine optische oder elektrische Funktionsschicht umfaßt.

12. Verbundmaterial nach Anspruch 11, **dadurch**
**gekennzeichnet, daß**
die Barrierebeschichtung derart aufgebaut ist, daß sie die Funktionsschicht integriert.

13. Verbundmaterial nach einem der Ansprüche 1 bis 12, **dadurch gekennzeichnet, daß** die Barrierebeschichtung eine Gradientenschicht umfaßt.

14. Verbundmaterial nach einem der Ansprüche 1 bis 13, **dadurch gekennzeichnet, daß** die Barrierebeschichtung eine stufenweise Änderung der Stöchiometrie und/oder der Struktur in einer Richtung senkrecht zur Oberfläche des Verbundmaterials aufweist.

15. Verbundmaterial nach Anspruch 1, **dadurch gekennzeichnet, daß** die TiOₓ-Schicht mit dem Substrat in Kontakt ist.

16. Verbundmaterial nach Anspruch 15, **dadurch gekennzeichnet, daß** die Wechselschicht eine TiOₓ/SiOₓ/TiOₓ/SiOₓ/-Wechselschicht umfaßt.

17. Verbundmaterial nach einem der Ansprüche 14 bis 16, **dadurch gekennzeichnet, daß** die Schichten der Wechselschicht eine Dicke in einem Bereich von 5 nm bis 100 nm aufweisen.

18. Verfahren zum Herstellen eines Verbundmaterials, umfassend ein Substratmaterial und wenigstens eine Barrierebeschichtung,
mit nachfolgenden Schritten:
- das Substratmaterial wird in einen Beschichtungsreaktor mit einer Gasatmosphäre eingebracht,
- in den Beschichtungsreaktor werden Precursor-Gase eingeleitet,
- im Beschichtungsreaktor wird mittels eines Pulses ein Plasma erzeugt, wodurch die Precursor-Gase mit der Gasatmosphäre im Beschichtungsreaktor reagieren, wobei
- mindestens einer der Parameter Sauerstoffdurchfluß und Precursor-Durchfluß derart eingestellt wird, daß auf dem Substrat eine Barrierebeschichtung abgeschieden wird, welche wenigstens eines der nachfolgenden Materialien umfaßt:
SiOₓ mit x<2, insbesondere mit 1,7 ≤ x < 2;
SiOₓ mit x>2, insbesondere mit 2 < x ≤ 2,5;
TiOₓ mit x<2, insbesondere mit 1,7 ≤ x < 2;
TiOₓ mit x>2, insbesondere mit 2 < x ≤ 2,5;
SnOₓ mit x<2, insbesondere mit 1,7 ≤ x < 2;
SnOₓ mit x>2, insbesondere mit 2 < x ≤ 2,5;
, wobei die Barrierebeschichtung eine TiOₓ/SiOₓ-Wechselschicht umfaßt.

19. Verfahren nach Anspruch 18, **dadurch gekennzeichnet, daß** die Pulse Mikrowellenpulse oder Hochfrequenzpulse einer PICVD-Anlage sind.

20. Verfahren nach Anspruch 19, **dadurch gekennzeichnet, daß**
die Mikrowellenpulse oder Hochfrequenzpulse über dielektrische Fenster oder Antennen eingekoppelt werden.

21. Verfahren nach Anspruch 19 oder 20, **dadurch**
**gekennzeichnet, daß**
die Mikrowellenpulse im Frequenzbereich 90 - 3000 MHz liegen.

22. Verfahren nach Anspruch 19 oder 20, **dadurch gekennzeichnet, daß** die Hochfrequenzpulse im Frequenzbereich unterhalb 90 MHz liegen.

23. Verfahren nach einem der Ansprüche 18 bis 22, **dadurch**
**gekennzeichnet, daß**
die Precursor-Gase eine oder mehrere der nachfolgenden Substanzen umfassen:
HMDSN, HMDSO, TMS, Silan in N2, TiCl4.

24. Verfahren nach einem der Ansprüche 18 bis 24, **dadurch**
**gekennzeichnet, daß**
die Gasatmosphäre eine
O₂-Atmosphäre,
N2-Atmosphäre,
N2 + NH3-Atmosphäre umfaßt.

25. Verfahren nach einem der Ansprüche 18 bis 24, **dadurch gekennzeichnet, daß** mindestens einer der Parameter Pulsdauer Pulspause, Mikrowellenleistung, Sauerstoffdurchfluß und Precursor-Durchfluß kontinuierlich oder stufenweise geändert wird.

26. Verfahren nach einem der Ansprüche 18 bis 25, **dadurch gekennzeichnet, daß** die Beschichtung mit einer Mikrowellenleistung in einem Bereich von 300 W bis 12 kW vorgenommen wird.

27. Verfahren nach einem der Ansprüche 18 bis 26, **dadurch gekennzeichnet, daß** die Beschichtung mit Pulsdauern von 0,1 bis 20 ms vorgenommen wird.

28. Verfahren nach einem der Ansprüche 18 bis 27, **dadurch gekennzeichnet, daß** der Beschichtungsreaktor evakuiert wird, nachdem das Substratmaterial in den Beschichtungsreaktor eingebracht wird und bevor Precursor-Gase eingeleitet werden.

29. Verfahren nach einem der Ansprüche 18 bis 28, wobei das Substratmaterial einen Hohlkörper umfaßt, **dadurch gekennzeichnet, daß** die Beschichtung auf der Innenseite und/oder der Außenseite des Hohlkörpers abgeschieden wird.

30. Verfahren nach Anspruch 29, wobei der Hohlkörper vor der Beschichtung gleichzeitig innen und außen evakuiert wird, bis ein Außendruck kleiner als 200mbar erreicht ist und wobei anschließend nur innenseitig bis zu einem Basisdruck kleiner als 1mbar abgepumpt wird.

31. Hohlkörper, umfassend ein Verbundmaterial nach einem der Ansprüche 1 bis 17.

32. Hohlkörper nach Anspruch 31, **dadurch gekennzeichnet, daß**
die Barrierebeschichtung auf die Innenseite des Hohlkörpers aufgebracht ist.

33. Hohlkörper nach Anspruch 32, **dadurch gekennzeichnet, daß**
die Barrierebeschichtung auf die Innen- und Außenseite des Hohlkörpers aufgebracht ist.

34. Hohlkörper nach einem der Ansprüche 31 bis 33, **dadurch gekennzeichnet, daß** das vom Hohlkörper umschlossene Volumen in einem Bereich von 10 ml bis 5000 ml liegt.

35. Flächenförmiges Substrat , umfassend ein Verbundmaterial nach einem der Ansprüche 1 bis 17.

36. Substrat nach Anspruch 35, **dadurch gekennzeichnet, daß** das Substrat eine Platte umfaßt.

## Claims

1. Composite material having a substrate material and at least one barrier coating on one side of the substrate material,
- wherein the barrier coating includes at least one of the following materials:
SiOₓ with x < 2, in particular with 1.7 ≤ x < 2;
SiOₓ with x > 2, in particular with 2 < x ≤ 2.5;
TiOₓ with x < 2, in particular with 1.7 ≤ x < 2;
TiOₓ with x > 2, in particular with 2 < x ≤ 2.5,
and the barrier coating includes a TiOₓ/SiOₓ alternating layer.

2. Composite material as claimed in Claim 1, having
a substrate material and at least one barrier coating on one side of the substrate material, **characterised in that**
the barrier coating is applied onto the substrate material by means of plasma impulse chemical vapour deposition (PICVD) and
the barrier coating includes at least one of the following materials:
amorphous hydrocarbons
NbₓO_{y} with x ∈ [0, 2], y ∈ [0, 5].

3. Composite material as claimed in Claim 1 or 2, **characterised in that**
the substrate is a synthetic material substrate.

4. Composite material as claimed in Claim 3, **characterised in that**
the synthetic material substrate includes one or several of the following materials:
polycyclic hydrocarbons
polycarbonates
polyethylene terephthalates
polystyrene
polyethylene, in particular HDPE
polypropylene
polymethylmetacrylate
PES.

5. Composite material as claimed in Claim 4,
**characterised in that**
the polycyclic carbon is COC.

6. Composite material as claimed in any one of Claims 1 to 5,
**characterised in that**
the substrate material is coated on both sides.

7. Composite material as claimed in any one of Claims 1 to 6,
**characterised in that**
the barrier coating [has] a thickness of less than 1000 nm.

8. Composite material as claimed in Claim 7, **characterised in that**
the barrier coating includes at least one closed monolayer.

9. Composite material as claimed in Claim 8, **characterised in that**
the thickness of the barrier coating is greater than 5 nm.

10. Composite material as claimed in any one of Claims 1 to 9, **characterised in that**
the barrier coating forms a barrier against matter from the atmosphere and/or matter which is in direct contact with the composite material and/or is contained in the substrate material or has been separated therefrom.

11. Composite material as claimed in any one of Claims 1 to 10, **characterised in that** the composite material includes an optical or electrical functional layer.

12. Composite material as claimed in Claim 11, **characterised in that**
the barrier coating is constructed such that it incorporates the functional layer.

13. Composite material as claimed in any one of Claims 1 to 12, **characterised in that** the barrier coating includes a gradient layer.

14. Composite material as claimed in any one of Claims 1 to 13, **characterised in that** the barrier coating comprises a gradual change in stoichiometry and/or in structure in a direction perpendicular to the surface of the composite material.

15. Composite material as claimed in Claim 1, **characterised in that** the TiOₓ layer is in contact with the substrate.

16. Composite material as claimed in Claim 15, **characterised in that** the alternating layer includes a TiOₓ/SiOₓ/TiOₓ/SiOₓ alternating layer.

17. Composite material as claimed in any one of Claims 14 to 16, **characterised in that** the layers of the alternating layer have a thickness in the range of 5 nm to 100 nm.

18. Method of producing a composite material including a substrate material and at least one barrier coating,
having the following steps:
- the substrate material is introduced into a coating reactor having a gas atmosphere,
- precursor gases are fed into the coating reactor,
- a plasma is produced in the coating reactor by means of a pulse, whereby the precursor gases react with the gas atmosphere in the coating reactor, wherein
- at least one of the parameters of oxygen flow rate and precursor flow rate is set such that a barrier coating is deposited onto the substrate, which barrier coating includes at least one of the following materials:
SiOₓ with x < 2, in particular with 1.7 ≤ x < 2;
SiOₓ with x > 2, in particular with 2 < x ≤ 2.5;
TiOₓ with x < 2, in particular with 1.7 ≤ x < 2;
TiOₓ with x > 2, in particular with 2 < x ≤ 2.5,
SnOₓ with x < 2, in particular with 1.7 ≤ x < 2;
SnOₓ with x > 2, in particular with 2 < x ≤ 2.5;
wherein the barrier coating includes a TiOₓ/SiOₓ alternating layer.

19. Method as claimed in Claim 18, **characterised in that** the pulses are microwave pulses or high frequency pulses from a PICVD system.

20. Method as claimed in Claim 19, **characterised in that**
the microwave pulses or high frequency pulses are inputted via dielectric windows or antennas.

21. Method as claimed in Claim 19 or 20, **characterised in that**
the microwave pulses are in the frequency range of 90-3000 MHz.

22. Method as claimed in Claim 19 or 20, **characterised in that** the high frequency pulses are in the frequency range below 90 MHz.

23. Method as claimed in any one of Claims 18 to 22, **characterised in that** the precursor gases include one or several of the following substances:
HMDSN, HMDSO, TMS, Silan in N2, TiCl4.

24. Method as claimed in any one of Claims 18 to 24 [*sic*], **characterised in that**
the gas atmosphere includes an
O₂ atmosphere,
N2 atmosphere,
N2 + NH3 atmosphere.

25. Method as claimed in any one of Claims 18 to 24, **characterised in that** at least one of the parameters of pulse duration, pulse interval, microwave power, oxygen flow rate and precursor flow rate are continuously or gradually changed.

26. Method as claimed in any one of Claims 18 to 25, **characterised in that** the coating procedure is effected with a microwave power in the range of 300 W to 12 kW.

27. Method as claimed in any one of Claims 18 to 26, **characterised in that** the coating procedure is effected with pulse durations of 0.1 to 20 ms.

28. Method as claimed in any one of Claims 18 to 27, **characterised in that** the coating reactor is evacuated after the substrate material is introduced into the coating reactor and before precursor gases are fed in.

29. Method as claimed in any one of Claims 18 to 28, wherein the substrate material includes a hollow body, **characterised in that** the coating is deposited onto the inner side and/or the outer side of the hollow body.

30. Method as claimed in Claim 29, wherein, prior to the coating procedure, the hollow body is evacuated simultaneously on the inside and outside until an external pressure of less than 200 mbar is achieved, and wherein pumping then occurs only on the inside, down to a base pressure of less than 1 mbar.

31. Hollow body including a composite material as claimed in any one of Claims 1 to 17.

32. Hollow body as claimed in Claim 31, **characterised in that**
the barrier coating is applied onto the inner side of the hollow body.

33. Hollow body as claimed in Claim 32, **characterised in that**
the barrier coating is applied onto the inner and outer side of the hollow body.

34. Hollow body as claimed in any one of Claims 31 to 33, **characterised in that** the volume surrounded by the hollow body is in the range of 10 ml to 5000 ml.

35. Laminar substrate including a composite material as claimed in any one of Claims 1 to 17.

36. Substrate as claimed in Claim 35, **characterised in that** the substrate includes a plate.

## Revendications

1. Matériau composite comportant une matière servant de substrat et au moins un revêtement barrière sur un côté du substrat,
dans lequel
le revêtement barrière comprend au moins l'une des matières suivantes :
SiOₓ avec x < 2, en particulier avec 1,7 ≤ x < 2 ;
SiOₓ avec x > 2, en particulier avec 2 < x ≤ 2,5 ;
TiOₓ avec x < 2, en particulier avec 1,7 ≤ x < 2 ;
TiOₓ avec x > 2, en particulier avec 2 < x ≤ 2,5 ;
et le revêtement barrière comprend une couche alternative TiOₓ/SiOₓ.

2. Matériau composite suivant la revendication 1, comportant
une matière servant de substrat et au moins
un revêtement barrière sur un côté du substrat, **caractérisé en ce que** le revêtement barrière est appliqué sur le substrat par vaporisation chimique par impulsions de plasma (PICVD) et le revêtement barrière comprend au moins l'une des matières suivantes :
hydrocarbures amorphes
NbₓO_{y} avec x ∈ [0,2], y ∈ [0, 5] .

3. Matériau composite suivant la revendication 1 ou 2, **caractérisé en ce que** le substrat est un substrat en matière synthétique.

4. Matériau composite suivant la revendication 3, **caractérisé en ce que** le substrat en matière synthétique comprend une ou plusieurs des matières suivantes
hydrocarbures polycycliques
polycarbonates
polyéthylènetéréphtalates
polystyrène
polyéthylène, en particulier polyéthylène haute densité
polypropylène
poly(méthacrylate de méthyle)
polyesters.

5. Matériau composite suivant la revendication 4, **caractérisé en ce que** l'hydrocarbure polyclique est un copolymère cyclooléfinique.

6. Matériau composite suivant l'une des revendications 1 à 5, **caractérisé en ce que** le substrat est revêtu des deux côtés.

7. Matériau composite suivant l'une des revendications 1 à 6, **caractérisé en ce que** le revêtement barrière a une épaisseur inférieure à 1000 nm.

8. Matériau composite suivant la revendication 7, **caractérisé en ce que** le revêtement barrière comprend au moins une couche monomoléculaire fermée.

9. Matériau composite suivant la revendication 8, **caractérisé en ce que** l'épaisseur du revêtement barrière est supérieure à 5 nm.

10. Matériau composite suivant l'une des revendications 1 à 9, **caractérisé en ce que** le revêtement barrière forme une barrière contre des substances venant de l'atmosphère et/ou des substances qui sont directement en contact avec le matériau composite et/ou sont contenues dans le substrat ou en sont éliminées.

11. Matériau composite suivant l'une des revendications 1 à 10, **caractérisé en ce que** le matériau composite comprend une couche fonctionnelle optique ou électrique.

12. Matériau composite suivant la revendication 11, **caractérisé en ce que** le revêtement barrière est constitué de façon telle qu'il intègre la couche fonctionnelle.

13. Matériau composite suivant l'une des revendications 1 à 12, **caractérisé en ce que** le revêtement barrière comprend une couche à gradient.

14. Matériau composite suivant l'une des revendications 1 à 13, **caractérisé en ce que** le revêtement barrière présente une variation échelonnée de stoechiométrie et/ou de structure dans une direction perpendiculaire à la surface du matériau composite.

15. Matériau composite suivant la revendication 1, **caractérisé en ce que** la couche de TiOₓ est en contact avec le substrat.

16. Matériau composite suivant la revendication 15, **caractérisé en ce que** la couche alternative comprend une couche alternative formée de TiOₓ/SiOₓ/TiOₓ/SiOₓ.

17. Matériau composite suivant l'une des revendications 14 à 16, **caractérisé en ce que** les couches de la couche alternative présentent une épaisseur comprise dans une plage de 5 nm à 100 nm.

18. Procédé de fabrication d'un matériau composite comprenant une matière servant de substrat et au moins un revêtement barrière, comportant les étapes suivantes :
- la matière servant de substrat est mise en place dans un réacteur de revêtement renfermant une atmosphère gazeuse,
- un courant de gaz précurseurs est introduit dans le réacteur de revêtement,
- un plasma est produit au moyen d'une impulsion dans le réacteur de revêtement, ce qui fait réagir les gaz précurseurs avec l'atmosphère gazeuse contenue dans le réacteur de revêtement,
- au moins l'un des paramètres débit d'oxygène et débit de précurseur étant alors réglé de manière qu'il se dépose sur le substrat un revêtement barrière qui comprend au moins l'une des matières suivantes :
SiOₓ avec x < 2, en particulier avec 1,7 ≤ x < 2;
SiOₓ avec x > 2, en particulier avec 2 < x ≤ 2,5 ;
TiOₓ avec x < 2, en particulier avec 1,7 ≤ x < 2 ;
TiOₓ avec x > 2, en particulier avec 2 < x ≤ 2,5;
SnOₓ avec x < 2, en particulier avec 1,7 ≤ x < 2;
SnOₓ avec x > 2, en particulier avec 2 < x ≤ 2,5 ;
le revêtement barrière comprenant une couche alternative TiOₓ/SiOₓ.

19. Procédé suivant la revendication 18, **caractérisé en ce que** les impulsions sont des impulsions de micro-ondes ou des impulsions de haute fréquence d'une installation de PICVD.

20. Procédé suivant la revendication 19, **caractérisé en ce que** les impulsions de micro-ondes ou les impulsions de haute fréquence sont injectées par l'intermédiaire de fenêtres diélectriques ou d'antennes.

21. Procédé suivant la revendication 19 ou 20, **caractérisé en ce que** les impulsions de micro-ondes se situent dans la plage de fréquences de 90 à 3000 MHz.

22. Procédé suivant l'une des revendications 19 ou 20, **caractérisé en ce que** les impulsions de haute fréquence se situent dans la plage de fréquences en dessous de 90 MHz.

23. Procédé suivant l'une des revendications 18 à 22, **caractérisé en ce que** les gaz précurseurs comprennent l'une ou plusieurs des substances suivantes :
HMDSN, HMDSO, TMS, silane dans N₂, TiCl₄.

24. Procédé suivant l'une des revendications 18 à 24, **caractérisé en ce que** l'atmosphère gazeuse comprend
une atmosphère de O₂,
une atmosphère de N₂,
une atmosphère de N₂ + NH₃.

25. Procédé suivant l'une des revendications 18 à 24, **caractérisé en ce qu'**au moins l'un des paramètres durée des impulsions, intervalle entre impulsions, puissance des micro-ondes, débit d'oxygène et débit de précurseurs est amené à varier en continu ou graduellement.

26. Procédé suivant l'une des revendications 18 à 25, **caractérisé en ce que** le revêtement est effectué avec une puissance de micro-ondes située dans une plage de 300 W à 12 kW.

27. Procédé suivant l'une des revendications 18 à 26, **caractérisé en ce que** le revêtement est effectué avec des durées d'impulsions de 0,1 à 20 ms.

28. Procédé suivant l'une des revendications 18 à 27, **caractérisé en ce qu'**un vide est créé dans le réacteur de revêtement après que la matière servant de substrat a été mise en place dans le réacteur de revêtement et avant l'introduction du courant de gaz précurseurs.

29. Procédé suivant l'une des revendications 18 à 28, dans lequel la matière formant le substrat consiste en un corps creux, **caractérisé en ce que** le revêtement est déposé à la face interne et/ou à la face externe du corps creux.

30. Procédé suivant la revendication 29, dans lequel le corps creux, avant le revêtement, est mis sous vide en même temps intérieurement et extérieurement jusqu'à ce qu'une pression externe inférieure à 200 mbar ait été atteinte, après quoi le vide n'est produit que du côté interne jusqu'à une pression de base inférieure à 1 mbar.

31. Corps creux comprenant un matériau composite suivant l'une des revendications 1 à 17.

32. Corps creux suivant la revendication 31, **caractérisé en ce que** le revêtement barrière est appliqué sur le côté interne du corps creux.

33. Corps creux suivant la revendication 32, **caractérisé en ce que** le revêtement barrière est appliqué sur les côtés interne et externe du corps creux.

34. Corps creux suivant l'une des revendications 31 à 33, **caractérisé en ce que** le volume délimité par le corps creux se situe dans une plage de 10 ml à 5000 ml.

35. Substrat plan, comprenant un matériau composite suivant l'une des revendications 1 à 17.

36. Substrat suivant la revendication 35, **caractérisé en ce que** le substrat comprend une plaque.
